# EUROPEAN PATENT APPLICATION

(11) **EP 2 031 951 A2**
(43) Date of publication of application: **04.03.2009**
(21) Application number: 08008066.6
(22) Date of filing: 25.04.2008
(51) Int. Cl.: H05K 9/00

(54) **Shield case device and display apparatus**

(30) Priority: 03.09.2007 JP 2007228200
(71) Applicant: KABUSHIKI KAISHA TOSHIBA, Tokyo (JP)
(72) Inventor: Watanabe, Tetsuji, Minato-ku Tokyo (JP)
(74) Representative: HOFFMANN EITLE

(57) **Abstract**

According to one embodiment, a shield case device (18) includes: a shield case (25); a heating element (26) that is mounted on a circuit board (27) housed in the shield case; and a heat conducting member (28) that is provided between the shield case and the heating element, the heat conducting member thermally conducted to the shield case and the heating element, wherein the heat conducting member includes a first contact portion (29) which is in contact with the shield case and a second contact portion (30) which is in contact with the heating element, wherein the shape of the heat conducting member is a chimney structure having a ventilation duct.

## Description

### BACKGROUND

### 1. Field

One embodiment of the invention relates to a shield case device serving to block an electromagnetic wave and comprising a heat transfer member for transferring a heat generated from a circuit component to a shield case, and a display apparatus.

### 2. Description of the Related Art

For example, there has been disclosed the following insulating shield device serving to prevent an electromagnetic wave from leaking to surroundings. The insulating shield device comprises a component serving as a source for generating an electromagnetic wave noise, a heat radiating plate for radiating a heat of the component to the surroundings, an inner shield case for accommodating the component, and an outer shield case for accommodating the inner shield case. In the insulating shield device, the heat radiating plate has upper and side edges abutting on an internal surface of the inner shield case. Moreover, a heat radiating hole for radiating the heat generated from the component to an outside is formed on each of upper surfaces of the inner and outer shield cases.

The insulating shield device also exhibits a heat radiating effect of the component by transferring the heat generated from the component to the shield case while preventing a leakage of the electromagnetic wave noise. Moreover, the heat generated from the component is not only transferred to the shield case but is discharged to the outside of the outer shield case via a heat radiating hole (for example, see JP-A-2001-332884).

In the conventional insulating shield device, however, a place in which the heat radiating hole is to be disposed is limited to the upper surfaces of the inner and outer shield cases. Therefore, there is a possibility that an air convection might be hard to generate. Moreover, the insulating shield device does not have a structure in which an air flow is controlled. For this reason, it is preferable that air warmed up by the heat radiating plate should exactly go up and should be then discharged from the heat radiating hole. In the case in which the air is diffused to the surroundings, however, there is a possibility that the air might stay in the inner shield case and might be left unradiated.

### SUMMARY OF THE INVENTION

One object of the invention is to provide a shield case device capable of blocking an electromagnetic wave and implementing an efficient heat radiation of a circuit component.
According to one aspect, a shield case device includes: a shield case; a heating element that is mounted on a circuit board housed in the shield case; and a heat conducting member that is provided between the shield case and the heating element, the heat conducting member thermally conducted to the shield case and the heating element, wherein the heat conducting member includes a first contact portion which is in contact with the shield case and a second contact portion which is in contact with the heating element, wherein the shape of the heat conducting member is a chimney structure having a ventilation duct.
According to another aspect, the heat conducting member has a plurality of ventilation ducts extended in parallel with the circuit board in a position between the first contact portion and the second contact portion.
According to another aspect, wherein the ventilation ducts are extended in a vertical direction.
According to another aspect, the shield case has a plurality of ventilation holes that restrict transmission of radio wave while allowing air to go there through.
According to another aspect, the shield case device further includes: a heat conducting sheet having an elasticity, wherein the heat conducting sheet is provided in at least one of a position between the shield case and the heat conducting member and a position between the heat conducting member and the heating element.
According to another aspect, a display device includes: a housing; and a shield case housed in the housing, wherein the shield case device includes: a shield case; a heating element that is mounted on a circuit board housed in the shield case; and a heat conducting member that is provided between the shield case and the heating element, the heat conducting member thermally conducted to the shield case and the heating element, wherein the heat conducting member includes a first contact portion which is in contact with the shield case and a second contact portion which is in contact with the heating element, wherein the shape of the heat conducting member is a chimney structure having a ventilation duct.
According to another aspect, the heat conducting member has a plurality of ventilation ducts extended in parallel with the circuit board in a position between the first contact portion and the second contact portion.
According to another aspect, the ventilation ducts are extended in a vertical direction.
According to another aspect, the shield case has a plurality of ventilation holes that restrict transmission of radio wave while allowing air to go there through.
According to another aspect, the display device further comprising: a heat conducting sheet having an elasticity, wherein the heat conducting sheet is provided in at least one of a position between the shield case and the heat conducting member and a position between the heat conducting member and the heating element.

### BRIEF DESCRIPTION OF THE SEVERAL VIEWS OF THE DRAWINGS

A general architecture that implements the various feature of the invention will now be described with reference to the drawings. The drawings and the associated descriptions are provided to illustrate embodiments of the invention and not to limit the scope of the invention.
Fig. 1 is an exemplary perspective view showing a thin television according to an embodiment.
Fig. 2 is an exemplary sectional view taken along a vertical direction of the thin television illustrated in Fig. 1.
Fig. 3 is an exemplary perspective view showing a shield case device of the thin television illustrated in Fig. 2.
Fig. 4 is an exemplary sectional view taken along an F4 - F4 line illustrated in Fig. 3.
Fig. 5 is an exemplary view showing a heat transfer path in the shield case device illustrated in Fig. 4.
Fig. 6 is an exemplary perspective view showing an air convection state in the shield case device illustrated in Fig. 3.

### DETAILED DESCRIPTION

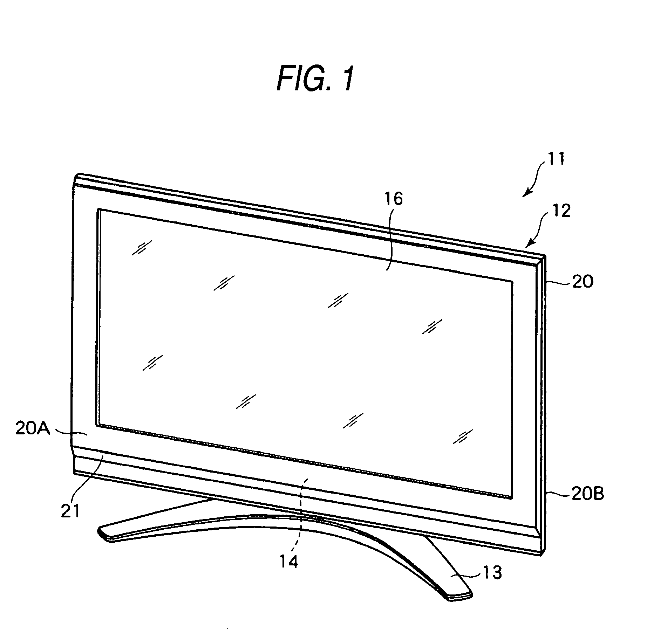

An embodiment applied to a thin television will be described below as an example of a display apparatus with reference to Figs. 1 to 6.

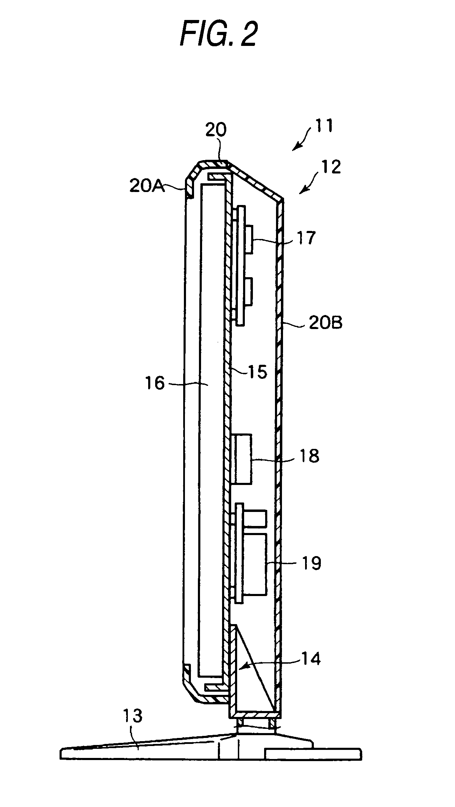

As shown in Figs. 1 and 2, a thin television 11 comprises a body unit 12, a stand 13 for supporting the body unit 12, and an angle regulating mechanism 14 provided between the body unit 12 and the stand 13 and serving to regulate an attachment angle of the body unit 12 to the stand 13.

The body unit 12 has a frame 15, a liquid crystal panel 16 attached to the frame 15, a panel controller 17 for driving the liquid crystal panel 16, a shield case device 18 and a power unit 19 which are connected to the panel controller 17, a housing 20 for surrounding them, and a speaker 21 provided in a lower part of the housing 20. The frame 15 is formed by pressing a metal plate, for example. The body unit 12 is attached to the stand 13 through the frame 15. The housing 20 includes a front cover 20A and a back cover 20B. The panel controller 17, the shield case device 18 and the power unit 19 are fixed to the frame 15 with a screw, for example.

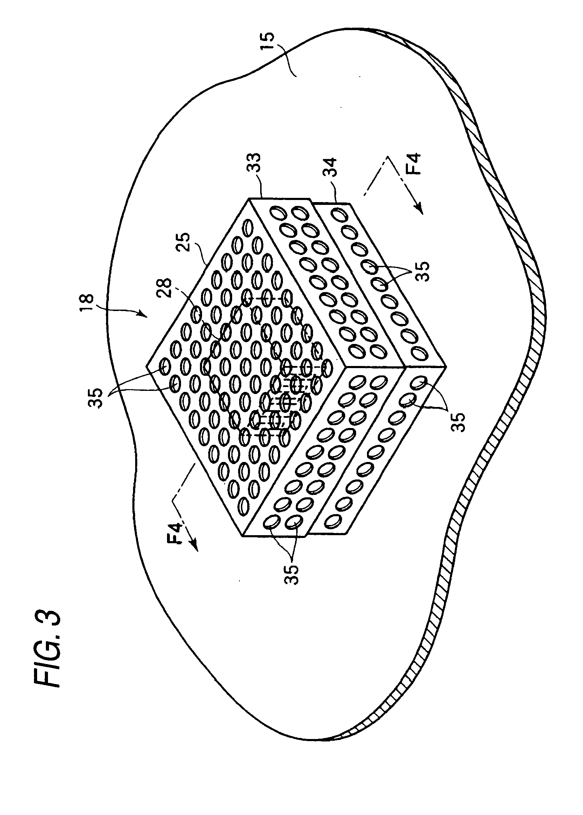

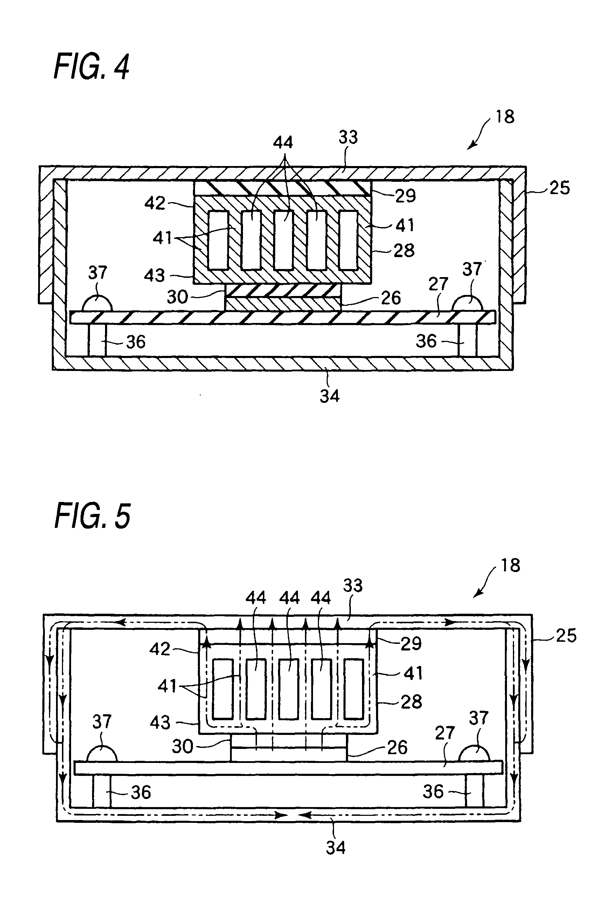

As shown in Figs. 3 and 4, the shield case device 18 includes a shield case 25 formed like a box, a printed circuit board 27 accommodated in the shield case 25 and mounting a circuit component 26 thereon, a heat conducting member 28 provided between the shield case 25 and the circuit component 26, a first heat conducting sheet 29 provided between the heat conducting member 28 and the shield case 25, and a second heat conducting sheet 30 provided between the circuit component 26 and the heat conducting member 28. The circuit component 26 is mounted on the printed circuit board 27.

The shield case 25 has a first member 33 disposed on an upper side and a second member 34 disposed on a lower side. The first member 33 and the second member 34 in the shield case 25 are formed by bending iron plates through pressing respectively, for example. The first member 33 is tightly fitted in the second member 34 and is thus fixed to the second member 34, for example. However, the first member 33 may be fixed to the second member 34 with a screw.

A plurality of vent holes 35 is disposed at a uniform density on each of surfaces of the shield case 25. The vent holes 35 are formed in a diameter of 3 to 4 mm, for example. By setting the diameter of the vent hole 35 to be equal to or smaller than 4 mm, it is possible to inhibit a transmission of most of an electromagnetic wave which is unnecessarily radiated. For this reason, in the shield case device 18 according to the embodiment, the vent holes 35 can permit a movement of air while inhibiting the transmission of the electromagnetic wave.

The printed circuit board 27 is a substrate for an image processing and mounts the circuit component 26 to be a central IC for the image processing thereon. However, the circuit component 26 is not restricted to the central IC for the image processing but may be other ICs, for example, an IC for a double speed processing. The printed circuit board 27 is fixed to the shield case 25 by fastening a screw 37 to a boss 36 formed on the second member 34 in the shield case 25. The first heat conducting sheet 29 and the second heat conducting sheet 30 are constituted by silicone rubber sheets respectively and have an elasticity, for example.

The heat conducting member 28 serves to conduct the heat of the circuit component 26 to the shield case 25. The heat conducting member 28 is a funnel type heat radiating plate having a plurality of vent ducts 44 and is constituted by an integral molded product through an extruded material such as an aluminum material, and has a high heat conductivity. A first contact portion 42 is closely bonded to the shield case 25 through the first heat conducting sheet 29. A second contact portion 43 is closely bonded to the circuit component 26 through the second heat conducting sheet 30. The funnel type indicates a shape in which a plurality of heat radiating plates 41 arranged in parallel with each other is coupled through the first contact portion 42 and the second contact portion 43 which are disposed in a perpendicular direction thereto.

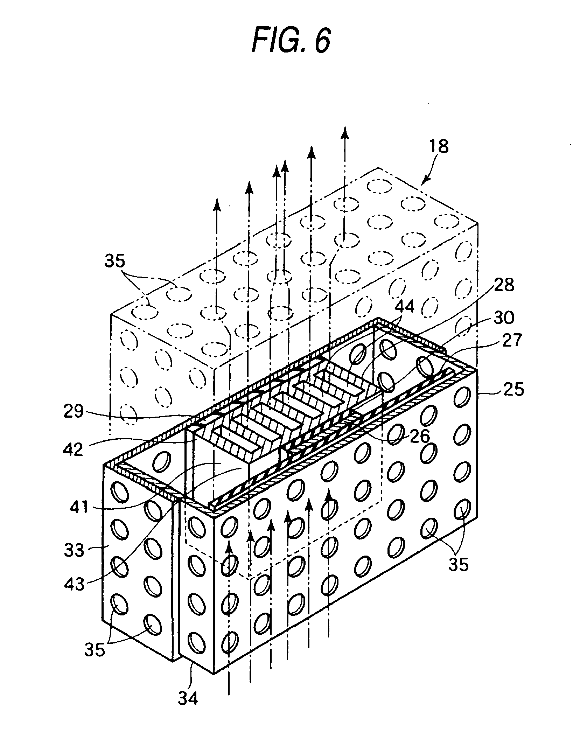

As shown in Fig. 4, the vent duct 44 is extended in a parallel direction with the printed circuit board 27. As shown in Figs. 2 and 6, the vent duct 44 is extended in a vertical direction. A plurality of vent ducts 44 is arranged in a line in the parallel direction with the printed circuit board 27.

Subsequently, the function of the shield case device 18 according to the embodiment will be described with reference to Figs. 5 and 6. The shield case device 18 according to the embodiment can block an electromagnetic wave generated from the circuit component 26 and can radiate the heat generated from the circuit component 26 to surroundings.

As shown in Fig. 5, the heat generated from the circuit component 26 is transferred to the heat conducting member 28 via the second heat conducting sheet 30. As shown in Fig. 6, a part of the heat is transferred to air in the vent duct 44. The vent duct 44 is extended in the vertical direction. Therefore, the air warmed up by the heat goes up and is then discharged from an upper end of the vent duct 44. The air discharged from the upper end of the vent duct 44 is discharged from the vent hole 35 of the shield case 25 to the outside. On the other hand, fresh air is supplied from a lower end of the vent duct 44. Consequently, an air convection is generated in the vicinity of the vent duct 44. In the embodiment, thus, the air flow warmed up by the heat of the circuit component 26 is defined by the vent duct 44. Therefore, the heat can be smoothly radiated from the circuit component 26 and the heat conducting member 28.

As shown in Fig. 5, moreover, the heat which is not radiated through the vent duct 44 is transferred to the first member 33 and the second member 34 in the shield case 25 through the second heat conducting sheet 30. Consequently, the heat is uniformly diffused into the shield case 25 so that the circuit component 26 is promoted to be cooled. Although both the first heat conducting sheet 29 and the second heat conducting sheet 30 are provided to enhance an adhesion property in the embodiment, only one of the first heat conducting sheet 29 and the second heat conducting sheet 30 may be provided to enhance the adhesion property thereof.

The embodiment of the thin television 11 has been described above. According to the embodiment, the thin television 11 to be the display apparatus comprises the housing 20 and the shield case device 18 accommodated in the housing 20, and the shield case device 18 includes the shield case 25, the printed circuit board 27 accommodated in the shield case 25 and mounting the circuit component 26 thereon, and the heat conducting member 28 provided between the shield case 25 and the circuit component 26 and serving to transfer the heat of the circuit component 26 to the shield case 25, and the heat conducting member 28 is a funnel type heat radiating plate having a vent duct structure and has the first contact portion 42 which is closely bonded to the shield case 25 and the second contact portion 43 which is closely bonded to the circuit component 26.

According to the structure, the adhesion property can be enhanced between the circuit component 26 and the shield case 25 through the first contact portion 42 and the second contact portion 43. Therefore, it is possible to enhance a heat conducting performance from the circuit component 26 to the shield case 25. Since the heat conducting member 28 is the funnel type heat radiating plate having a vent duct structure, moreover, it cannot only transfer the heat from the circuit component 26 to the shield case 25 but can discharge a part of the heat into the air in the middle of the heat conduction. Consequently, it is possible to enhance a cooling efficiency of the circuit component 26. As described above, it is possible to maintain a shielding property for an electromagnetic wave and to enhance a heat radiating property of the circuit component 26.

In this case, the heat conducting member 28 has a plurality of vent ducts 44 extended in the parallel direction with the printed circuit board 27 in a position between the first contact portion 42 and the second contact portion 43. According to the structure, it is possible to define an air flow in the parallel direction with the printed circuit board 27 through the ducts taking a shape of a tube. Consequently, the air warmed up by the heat discharged from the heat radiating plate 41 is diffused into the surroundings. Thus, it is possible to prevent the warm air from staying in the shield case 25.

In this case, the vent duct 44 is extended in the vertical direction. According to the structure, the air warmed up in the vent duct 44 goes up along the vent duct 44, and furthermore, is discharged from the upper end of the vent duct 44. Moreover, the fresh air is supplied from the lower end of the vent duct 44. Consequently, the air flow is formed in the shield case 25 and the air warmed up does not stay in the shield case 25. Thus, it is possible to efficiently radiate the heat through the heat conducting member 28.

In this case, the shield case 25 is formed like a box and a plurality of vent holes 35 capable of permitting a movement of the air while inhibiting a transmission of an electromagnetic wave is disposed at a uniform density on each of the surfaces of the shield case 25. According to the structure, the air warmed up in the vent duct 44 is discharged to the outside of the shield case 25 and can be thus prevented from staying in the shield case 25. Moreover, the fresh air can be sucked from the outside of the shield case 25. By setting a diameter of the vent hole 35 to be 3 to 4 mm, for example, it is possible to easily inhibit the transmission of the electromagnetic wave while permitting the movement of the air.

In this case, the heat conducting sheet 29 or 30 having an elasticity is provided in at least one of the position between the shield case 25 and the heat conducting member 28 and the position between the heat conducting member 28 and the circuit component 26. According to the structure, it is possible to enhance an adhesion property in the position between the shield case 25 and the heat conducting member 28 and the position between the heat conducting member 28 and the circuit component 26. Consequently, it is possible to prevent a clearance from being generated between them and to enhance the heat conducting property from the circuit component 26 to the shield case 25.

The display apparatus according to the invention is not restricted to the thin television 11 but can also be executed as a display for a personal computer, for example. In addition, the display apparatus can be variously changed without departing from the scope of the invention and can be thus executed.

## Claims

1. A shield case device comprising:
a shield case;
a heating element that is mounted on a circuit board housed in the shield case; and
a heat conducting member that is provided between the shield case and the heating element, the heat conducting member thermally conducted to the shield case and the heating element,
wherein the heat conducting member includes a first contact portion which is in contact with the shield case and a second contact portion which is in contact with the heating element,
wherein the shape of the heat conducting member is a chimney structure having a ventilation duct.

2. The shield case device according to claim 1, wherein the heat conducting member has a plurality of ventilation ducts extended in parallel with the circuit board in a position between the first contact portion and the second contact portion.

3. The shield case device according to claim 2, wherein the ventilation ducts are extended in a vertical direction.

4. The shield case device according to claim 3, wherein the shield case has a plurality of ventilation holes that restrict transmission of radio wave while allowing air to go there through.

5. The shield case device according to claim 4, further comprising:
a heat conducting sheet having an elasticity,
wherein the heat conducting sheet is provided in at least one of a position between the shield case and the heat conducting member and a position between the heat conducting member and the heating element.

6. A display device comprising:
a housing; and
a shield case housed in the housing,
wherein the shield case device includes:
a shield case;
a heating element that is mounted on a circuit board housed in the shield case; and
a heat conducting member that is provided between the shield case and the heating element, the heat conducting member thermally conducted to the shield case and the heating element,
wherein the heat conducting member includes a first contact portion which is in contact with the shield case and a second contact portion which is in contact with the heating element,
wherein the shape of the heat conducting member is a chimney structure having a ventilation duct.

7. The display device according to claim 6, wherein the heat conducting member has a plurality of ventilation ducts extended in parallel with the circuit board in a position between the first contact portion and the second contact portion.

8. The display device according to claim 7, wherein the ventilation ducts are extended in a vertical direction.

9. The display device according to claim 8, wherein the shield case has a plurality of ventilation holes that restrict transmission of radio wave while allowing air to go there through.

10. The display device according to claim 9, further comprising:
a heat conducting sheet having an elasticity,
wherein the heat conducting sheet is provided in at least one of a position between the shield case and the heat conducting member and a position between the heat conducting member and the heating element.
